# EUROPEAN PATENT SPECIFICATION

(11) **EP 3 840 366 B1**
(45) Date of publication and mention of the grant of the patent: **07.10.2026**
(21) Application number: 20214848.2
(22) Date of filing: 17.12.2020
(51) Int. Cl.: H04N 25/57, H04N 25/77, H04N 25/40

(54) **IMAGING DEVICE**
BILDGEBUNGSVORRICHTUNG
DISPOSITIF D'IMAGERIE

(30) Priority: 20.12.2019 GB 201919089
(43) Date of publication of application: 23.06.2021
(73) Proprietor: Teledyne UK Limited, Chelmsford, Essex CM1 2QU (GB)
(72) Inventor: STEFANOV, Konstantin, Milton Keynes, MK7 6AA (GB)
(74) Representative: HGF

(56) References cited:
- EP-A1- 2 346 079
- US-A1- 2008 074 524
- US-B1- 8 928 792
- DONGSOO KIM ET AL: "A Dual-Capture Wide Dynamic Range CMOS Image Sensor Using Floating-Diffusion Capacitor", IEEE TRANSACTIONS ON ELECTRON DEVICES, IEEE SERVICE CENTER, PISACATAWAY, NJ, US, vol. 54, no. 10, 1 October 2008 (2008-10-01), pages 2590 - 2594, XP011235105, ISSN: 0018-9383, DOI: 10.1109/TED.2008.2003023
- JAVIER TIFFENBERG ET AL: "Single-electron and single-photon sensitivity with a silicon Skipper CCD", ARXIV.ORG, CORNELL UNIVERSITY LIBRARY, 201 OLIN LIBRARY CORNELL UNIVERSITY ITHACA, NY 14853, 31 May 2017 (2017-05-31), XP081277101, DOI: 10.1103/PHYSREVLETT.119.131802

## Description

### FIELD

Embodiments described herein relate generally to devices and methods for imaging, particularly imaging using pinned photodiodes.

### BACKGROUND

Imaging devices with high dynamic range (HDR) are used for imaging of scenes with large differences between the illumination levels, either within a single scene or between different operating conditions, such as imaging at night and during the day. Typical applications are in automotive imaging, surveillance, robotics, spectroscopy and astronomy. The dynamic range (DR) of a sensor is calculated as the maximum output signal over its RMS readout noise, and sensors with DR above 100 dB are generally considered to be in the HDR category.

Modern CMOS image sensors have high conversion gain (CG) in order to achieve low readout noise performance. For example, the CG could be between 50 µV and 100 µV per electron (µV/e-) or even higher, which allows the readout noise to be below 2 e- RMS. The output voltage signal from a pinned photodiode (PPD) rarely exceeds 2 V due to power supply limitations on the output swing, which corresponds to charge handling capacity of 20 ke- at CG=100 µV/e-. The dynamic range of such sensor, calculated as the maximum output signal over the RMS noise, would be 20 ke-/2 e- = 10⁴, or 80 dB.

This output signal can be significantly lower than the full well capacity of the PPD. A 10 µm PPD pixel can store more than 100 ke-, which would correspond to a dynamic range of 50000 (94 dB) at 2 e- noise. However, if CG=100 µV/e- is used as in the previous example, the output voltage swing would need to be 10 V, and this would saturate the output of the sensor. If a lower conversion gain is used to accommodate the larger output signal, the readout noise would increase too, limiting the achievable dynamic range.

Methods employed to achieve dynamic range above 100 dB in PPD CMOS image sensors include: taking and processing multiple images taken at different exposure times; dynamically changing the conversion gain of the sensor by allowing the excess charge to overflow into a capacitor; allowing the charged stored in the PPD to be transferred to one of two sense nodes having different conversion gains; and employing two separate photodiodes with different photosensitivity.

There is a continuing need to increase the DR of PPD-based CMOS image sensors above 100 dB while preserving their low noise performance.

US 8928 792 B1 relates to a CMOS image sensor with global shutter, rolling shutter and variable conversion gain, having pixels employing several bulk charge modulated device (BCMD) transistors couple to a single photodiode and dual gate BCMD transistors for charge storage and sensing.

EP 2 346 079 A1 relates to a pixel structure with multiple transfer gates.

"A Dual-Capture Wide Dynamic Range CMOS Image Sensor Using Floating-Diffusion Capacitor", IEE Transactions of Electron Devices, vol. 54, no. 10, 1 October 20008, pages 2590-2594 relates to a dual-capture wide dynamic range CMOS image sensor using an in-pixel floating diffusion (FD) storage capacitor.

"Single-electron and single-photon sensitivity with a silicon Skipper CCD", arxiv.org, Cornell University Library, 201 Olin Library Cornell University Ithaca, 31 May 2017 relates to a non-destructive readout system that uses a floating-gate amplifier on a thick fully depleted charge coupled device. US 2008/074524 A1 discloses an imaging device having high dynamic range.

### SUMMARY

According to the invention, an imaging device is provided as set out in claim 1.

For the avoidance of doubt, by non-destructively producing a signal representative of the charge generated in the pinned photodiode, it is meant that a signal is produced without removal of charge from the substrate. Thus, a non-destructive charge measurement permits further, subsequent measurement of the charge generated in the photodiode. The subsequent measurement may be made non-destructively or otherwise. The imaging device therefore allows several measurements of the same signal.

A pinned photodiode is a light sensitive (photodiode) region of a first doping type on a substrate of a second doping type with an implant ("pinning") layer of the second doping type formed over the photodiode region at the surface of the substrate, wherein the first and second doping types are of opposite polarity.

The conversion gain of a signal is the number of volts produced per electron.

More than two measurements of the charge generated in the pixel may be made.

In an embodiment, the subsequent second path is configured to destructively produce a signal representative of the charge generated in the pinned photodiode.

For the avoidance of doubt, destructively producing a signal means that the signal is produced by the non-reversible conversion of charge to voltage.

In an embodiment, the imaging device is configured to produce at least one non-destructive readout of the charge generated in the photodiode followed by a destructive readout. The imaging device may be configured to produce two or more non-destructive readouts of the charge generated in the photodiode.

The imaging device may be operable to produce only one signal via the first path or via the second path.

In an embodiment, the conversion gain of the second path may be higher than the conversion gain of the first path. In an embodiment, the conversion grain ratio of the second path is 2 to 20 times higher than the conversion gain ratio of the first path. In an embodiment, the conversion grain ratio of the second path is 5 to 10 times higher than the conversion gain ratio of the first path. The conversion gain ratio of the two paths may be approximately 10. Obtaining two signals with differing gains enables the sensor to have a high dynamic range.

The circuitry defining the first path and the circuitry defining the second path may be dedicated to the first and second paths respectively. Some of the circuitry defining the first path and the circuitry defining the second path may be common to both paths. Some components may be shared by both first and second paths. This enables space dedicated to the circuitry to be reduced and the size of the pinned photodiode to be increased.

In an embodiment, the circuitry defining the first path is circuitry configured to produce a signal representative of the charge generated in the pinned photodiode via capacitive coupling to charge in the substrate. In an embodiment, the circuitry defining the first path comprises: a sense gate electrode formed on the substrate and capacitively coupled to charge in the imaging device; and circuitry configured to measure the voltage change of the sense gate.

In an embodiment the sense gate electrode is a floating gate electrode. A floating gate electrode is a gate electrode which is electrically isolated.

In an embodiment, the circuitry defining the second path may comprise: a sense node formed on the substrate and configured to receive charge transferred from the pinned photodiode; and circuitry configured to measure the voltage change of the sense node, so as to enable measurement of charge transferred from the pinned photodiode.

The sense node comprises a region formed on the substrate of opposing polarity to the substrate.

In an embodiment, the imaging device may further comprise a first region of the substrate located between the pinned photodiode and the sense node; a first gate electrode formed on the substrate and configured to control the transfer of charge from the pinned photodiode to the first region; a second gate electrode formed on the substrate and configured to control the transfer of charge between the first region and the sense node, and wherein the sense gate electrode is formed on the first region of the substrate and capacitively coupled to charge in the first region.

The first region of the substrate may be of a first doping type and the first gate electrode and the second gate electrode may both be formed on a region of the substrate of the first doping type.

The pinned photodiode may be formed on a region of the substrate of the first doping type, thus enabling surface channel mode charge transfer between the pinned photodiode and the sense node and enabling straightforward manufacture of the imaging device.

The pinned photodiode may be formed on a region of the substrate of the second doping type, wherein the first and second doping types are of opposing polarity, thereby enabling buried channel mode charge transfer, thereby improving charge transfer efficiency between the pinned photodiode and the sense node.

The first region of the substrate may be a first doping type, the second gate electrode may formed on a region of the substrate having the first doping type and the first gate electrode may formed on a region of the substrate having a second doping type, wherein the first and second doping types are of opposing polarity, thus enabling buried channel mode charge transfer, thereby improving charge transfer efficiency between the pinned photodiode and the sense node.

In an embodiment, the first gate electrode and the second gate electrode are further configured to control the transfer of charge from the first region back to the pinned photodiode. Thus, the charge can be measured at the sense gate before being returned to the pinned photodiode for further charge generation. Thus, several measurements of the charge can be taken during the course of charge generation.

In an embodiment, the circuitry defining the first path comprises: a sense gate electrode formed on the substrate and capacitively coupled to charge in the imaging device; and circuitry configured to measure the voltage change of the sense gate, the circuitry defining the second path comprises: a sense node formed on the substrate and configured to receive charge transferred from the pinned photodiode; and circuitry configured to measure the voltage change of the sense node, so as to enable measurement of charge transferred from the pinned photodiode, and the circuitry defining the first path is configured to measure the charge generated in the pinned photodiode via capacitive coupling to the sense gate during charge collection in the pinned photodiode. Thus, several measurements of the charge may be made during charge collection.

In an embodiment, the imaging device comprises an array of pinned photodiodes and the circuitry defining a subsequent second path are operative to produce signals representative of the charge generated in at least one of the pinned photodiodes.

In an embodiment, the circuitry defining a first path and the circuitry defining a subsequent second path are common to more than one pinned photodiode, i.e. more than one pinned photodiode may share the same circuitry.

The imaging device may comprise circuitry defining first and second paths for producing signals representative of the charge generated in the photodiodes for each individual pinned photodiode (i.e. one set of circuitry is dedicated to a particular pinned photodiode) or circuitry may be common to more than one pinned photodiode, or a mixture of the two. In an embodiment, the circuitry defining a first path and the circuitry defining a subsequent second path are dedicated to one pinned photodiode, and each pinned photodiode has its own dedicated circuitry. In an embodiment, some of the charge measurement circuitry is common to more than one pinned photodiode and some of the charge measurement circuitry is dedicated to individual pinned photodiodes.

In an embodiment, the imaging device may be configured to discard the signal produced by the second path when the signal produced by the first path exceeds a threshold. This threshold may indicate that the signal produced by the second path is in saturation. Thus, the signal produced by the second path is discarded when it is in saturation.

The imaging device may be manufactured using CMOS techniques.

According to the invention, a method for operating of the imaging device is provided as set out in claim 11.

### BRIEF DESCRIPTION OF FIGURES

Arrangements of the present invention will be understood and appreciated more fully from the following detailed description, made by way of example only and taken in conjunction with drawings in which:
- Figure 1 shows an imaging device according to an embodiment;
- Figure 2 shows an example of a pixel comprising a pinned photodiode;
- Figure 3 shows a circuit diagram for the pixel of Figure 3;
- Figure 4 shows an example of a pixel acting according to an embodiment;
- Figure 5 shows a circuit diagram for the pixel of Figure 4;
- Figure 6 shows a timing diagram for reading out the signal from the pixel shown in Figure 4;
- Figure 7 shows a potential diagram for the pixel of Figure 4 for selected steps in the readout process;
- Figure 8 shows an imaging device according to an embodiment;
- Figure 9 shows a decision making process for signal processing according to an embodiment;
- Figure 10 shows a further potential diagram for the pixel of Figure 4;
- Figure 11 shows a pixel according to an embodiment;
- Figure 12 is a timing diagram for the pixel of Figure 11;
- Figure 13 shows a simulation result for electron concentration in a pixel according to an embodiment;
- Figure 14 shows a simulation result for electron concentration in a pixel according to an embodiment;
- Figure 15 shows the simulated voltage change on a sense gate of a pixel acting according to an embodiment;
- Figure 16 shows a pixel according to an embodiment;
- Figure 17 shows a pixel according to an embodiment;
- Figure 18 shows a pixel according to an embodiment;
- Figure 19 shows a timing diagram for signal readout from the pixel of Figure 18;
- Figure 20 shows a pixel according to an embodiment;
- Figure 21 shows a timing diagram for signal readout from the pixel of Figure 20;
- Figure 22 shows a timing diagram for signal readout from the pixel of Figure 18;
- Figure 23 shows a pixel according to an embodiment;
- Figure 24 shows a circuit diagram for the pixel of Figure 23;
- Figure 25 shows a timing diagram for signal readout from the pixel of Figure 23;
- Figure 26 shows a potential diagram for the pixel of Figure 23 for selected steps in the readout process;
- Figure 27 shows a TCAD simulation of the operation during charge collection of the pixel of Figure 23;
- Figure 28 shows a TCAD simulation of the operation following charge transfer to the sense node in the pixel of Figure 23;
- Figure 29 shows a simulation result for electron concentration in a pixel according to an embodiment;
- Figure 30 shows a simulation result for voltage on the sense gate of a pixel acting according to an embodiment;
- Figure 31 shows the circuit diagram of a pixel according to an embodiment; and
- Figure 32 shows the timing diagram for the pixel of Figure 31.

### DETAILED DESCRIPTION

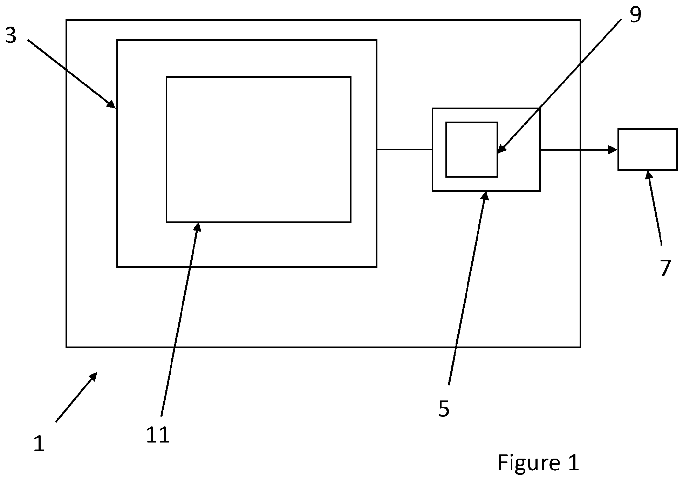

Figure 1 shows an imaging device 1 according to an embodiment. The imaging device 1 comprises a light sensing module 3 comprising a pixel array 11 having one or more pixels for sensing light incident on the imaging device.

Although we employ the term "light" here, this is by no means intended to be interpreted as meaning visible light. Indeed, imaging devices 1 and pixels according to embodiments may be employed for non-visible light imaging, such as infra-red imaging.

Pixels according to embodiments are discussed in more detail below. The pixels of the pixel array 11 may be covered with colour filters to enable the colour information of the light incident on each pixel to be recorded. The imaging device 1 further comprises an image processing module 5 comprising a processor 9 configured to process signals output from the pixel array 11 to determine the intensity of light (i.e. the number of photons) incident on each pixel of the pixel array 11.

The imaging device 1 further comprises an output 7 configured to output data relating to the intensity of the light incident on each pixel of the pixel array 11. The data may comprise an image. The imaging device 1 may be a digital imaging device and the image processing module 5 may further comprise an analogue to digital converter. In this case, the output from the imaging device 1 may comprise a digital signal.

The output 7 may be for example a direct image output, e.g. a screen or an output for an image data file that may be sent to a storage medium, networked, etc.

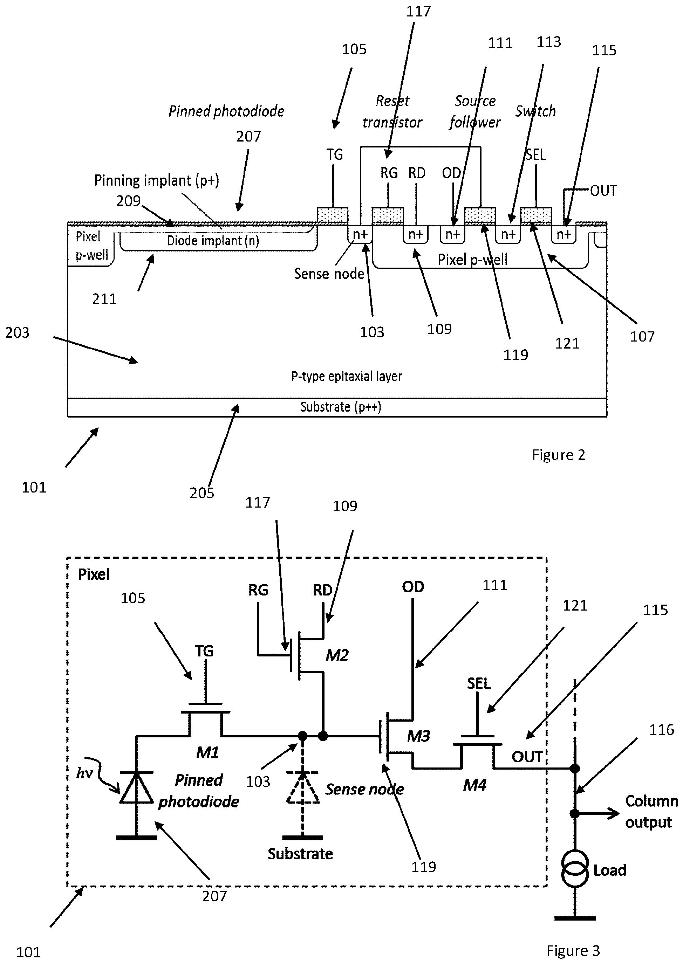

Figures 2 and 3 show an example of a Complementary Metal Oxide Semiconductor (CMOS) pixel comprising a pinned photodiode (PPD) acting as an optical element. A cross-sectional view of the pixel is given in Figure 2. Figure 3 shows the corresponding electronic schematic of the pixel. The same reference numerals have been employed for corresponding features in both figures.

A pinned photodiode is a photodiode comprising a layer of a first doping type implanted into an epitaxial layer of a second doping type, the layer of the first doping type itself being overlaid with a pinning layer of the second doping type. The first and second doping types are of opposing polarity.

Although specific doping polarities are described in association with examples and embodiments discussed below, the skilled person will appreciate that the doping polarities may be reversed.

Photons incident onto the surface of the PPD stimulate the generation of charge within it. A sense node comprising of a region of the first doping type is typically also embedded into the surface of the epitaxial layer. A gate electrode controls the transfer of charge from the PPD to the sense node where the charge is measured.

In the example of Figure 2, the pixel 101 comprises a p-type epitaxial layer 203 formed on a p++ substrate 205. The pinned photodiode 207 comprises a shallow p+ pinning layer 209 implanted over an n-type diode implant layer 211 at the surface of the p-type epitaxial layer 203.

The pixel further comprises a sense node 103 comprising an n+ region near the surface of the epitaxial layer 203. A transfer gate electrode 105 located on the surface of the epitaxial layer 203 controls the transfer of charge between the pinned photodiode 207 and the sense node 103.

The pixel further comprises a p-well 107 formed at the surface of the epitaxial layer 203. Within the p-well 107 are formed four n+ regions 109, 111, 113 and 115 which together form part of the circuitry for measuring the charge on the sense node, as will become apparent from the below discussion.

A gate electrode 117 is formed on the surface of the p-well layer 107 between the sense node 103 and the n+ region 109. A drain electrode is formed on the surface of n+ region 109, thereby enabling current from the sense node 103 to the drain 109 in response to the voltage applied to the gate electrode 117 that controls the transfer of charge between the sense node 103 and the n+ region 109. Thus, the gate electrode 117 acts as a reset gate, enabling the sense node 103 to be reset, with the n+ region acting as a reset drain. This will be discussed further below.

A further gate electrode 119 is formed on the surface of p-well layer 107 between the n+ region 111 and the n+ region 113. The gate electrode 119 is electrically connected to the sense node 103, thereby acting as a source follower for sense node 103. A drain electrode is formed on the surface of the n+ region 113. Yet a further gate electrode, select electrode 121 is formed on the surface of p-well layer 107 between the n+ region 113 and the n+ region 115. An output electrode is formed on the surface of the n+ region 115, thereby enabling an output current to be output via the column output 116 to the image processor 9. The role of these components will be described in detail below.

Typically, the gate electrodes are made of polycrystalline silicon and are isolated from the monocrystalline epitaxial silicon below by a thin layer of silicon dioxide.

Various methods of manufacturing the pixel of Figure 2 described above according to a variety of CMOS and image sensor technologies are well known in the art. In an example, a 180 nm image sensor process is employed. In this example, the epitaxial layer thickness is typically in the range between 5 µm and 18 µm, with resistivity ranging from 5 Ω.cm to 1000 Ω.cm. The pixel size of PPD image sensors can be from <1 µm to over 100 µm. The p-well is normally 1 µm deep and has doping concentration of around 10¹⁷ cm⁻³. The n-type PPD doping is adjusted to give pinning voltages between 0.8 V and 1.8 V, corresponding to doping concentration of around 10¹⁶ cm⁻³, and is between 0.5 µm and 1.5 µm deep. The p+ pinning implant is normally 0.1 µm thick and has doping concentration in excess of 10¹⁸ cm⁻³. The gate oxide for this technology is typically in the range between 5 nm and 10 nm.

Charge generated by light illumination is collected and stored in the PPD 207 and transferred to the sense node 103 by a pulsed voltage applied to the transfer gate (TG) 105. Immediately before the charge transfer the sense node 103 is reset by the transistor 117. The sense node 103 is buffered by the source follower 119 and its voltage sampled at the output OUT 115 when the transistor M4 is switched on. The sense node 103 voltage is sampled again immediately after the charge transfer from the PPD 207, allowing for efficient correlated double sampling (CDS) to be performed. The capacitance of the sense node 103 can be very small, resulting in very high charge-to-voltage conversion gain and low readout noise.

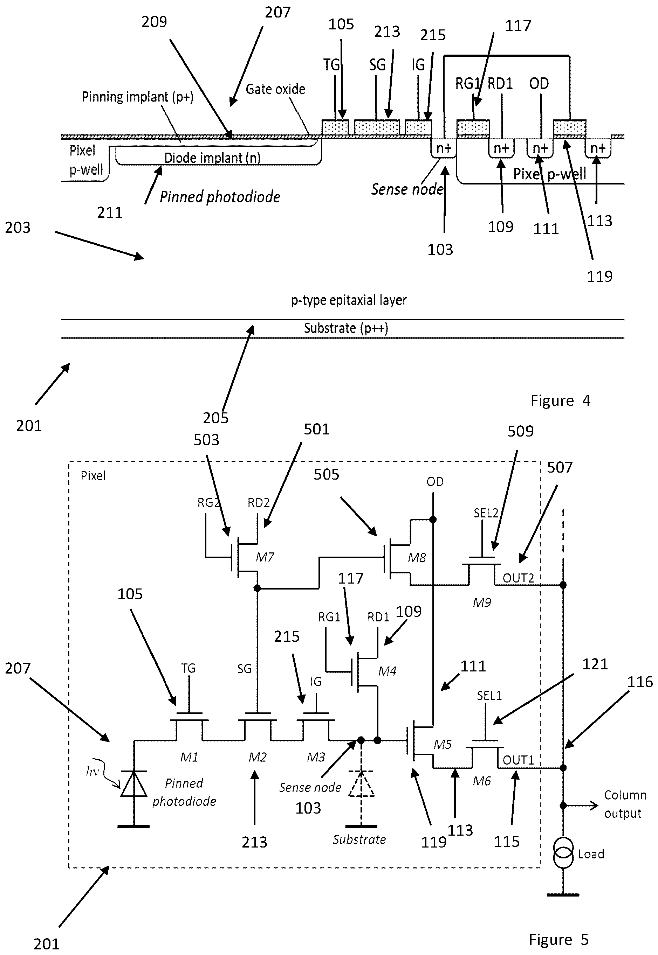

Figures 4 and 5 show a pixel 201 acting as an optical element according to an embodiment for use in the imaging device 1 of Figure 1. A cross-sectional view of the pixel is given in Figure 4. Figure 5 shows the corresponding electronic schematic of the pixel. The same reference numerals have been employed for corresponding features in both figures. Similarly, features corresponding to those in Figures 2 and 3 are indicated with the same reference numeral as employed in those figures. Note that certain features that appear in Figure 5 have been omitted from Figure 4 for clarity.

In addition to the features described above in relation to Figures 2 and 3, pixel 201 comprises two additional gates after the transfer gate (TG) 105 - a sense gate (SG) 213 and an isolation gate (IG) 215. After the charge has been collected in the PPD 207, it is then transferred via the TG 105 to the SG 213, which has been biased in advance to create a potential well under it, and is floating.

The sense gate 213 is connected to a reset transistor comprising reset drain 501 and reset gate 503. The sense gate 213 is further connected to gate 505, which acts as a source follower to buffer the potential charge on SG 213, induced by the stored charge under it. The pixel comprises a further transistor 509, configured to enable the voltage of the SG 213 to be sampled at the output OUT2 507 when the transistor 509 is switched on.

Thus, the potential change on SG 213, induced by the stored charge under it, is buffered by a source follower 505 and read out non-destructively via a separate readout path. This readout path has low conversion gain due to the capacitive charge sensing at the SG 213.

The skilled person will appreciate that other configurations of readout paths for the voltage induced in the sense gate 213 are possible.

During the non-destructive readout the isolation gate (IG) 215 is biased low to prevent the charge from escaping to the sense node 103. After charge measurement using the SG 213, the charge is then transferred to the sense node 103 by biasing IG 215 high and read out by a second source follower 119.

Figure 5 shows the full circuit in the pixel and the two readout paths. The high conversion gain path is provided by the transistors 117, 119 and 121 and is identical to the readout circuitry shown in the pixel of Figures 2 and 3. The low conversion gain, non-destructive path is provided by the transistors 503, 505 and 509.

The conversion gain of the readout path provided by transistors 503, 505 and 509 is low due to the much larger capacitance of SG 213 relative to the sense node 103 capacitance, and the capacitive charge measurement using a floating gate. The low conversion gain should allow charge in excess of 100 ke- to be measured without limitations imposed by the operating voltage of the device. At the same time, the path through transistors 117, 119 and 121 can provide very high conversion gain due to the small sense node 103 capacitance, and correspondingly very low readout noise.

Note that the pixel 201 can be operated in exactly the same manner as pixel 101 described in relation to Figures 1 and 2 above simply by opening the isolation gate IG 215 and performing only the destructive measurement.

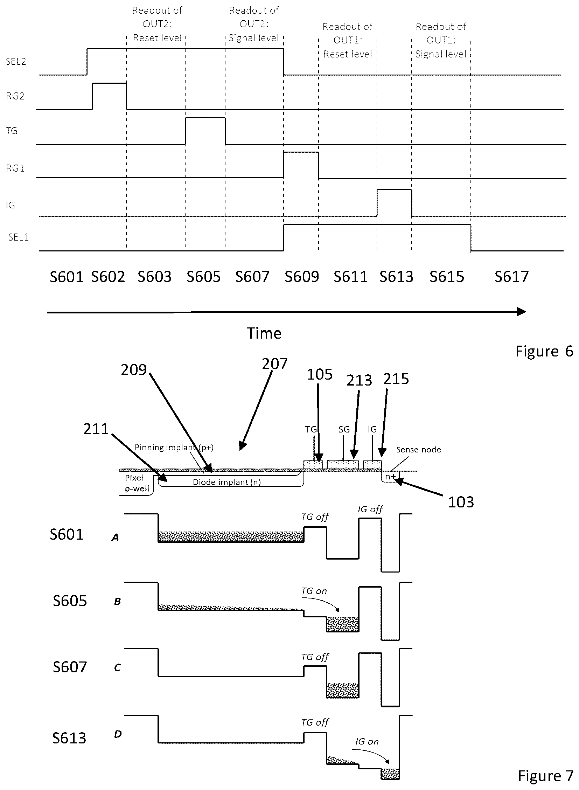

Figure 6 shows a timing diagram for reading out the signal from pixel 201 according to an embodiment, with time increasing from left to right. The diagram shows the voltage applied to the transfer gate 105 (TG), the isolation gate 215 (IG), the reset gate 503 for the low gain readout circuit (RG2), the reset gate 117 for the high gain readout circuit (RG2), the select electrode 509 for the low gain circuit (SEL2) and the select electrode 121 for the high gain circuit (SEL1).

Figure 7 shows a potential diagram for the pinned photodiode 207, the transfer gate 105 (TG), the sense gate 213 (SG), the isolation gate 215 (IG) and the sense node 103 of the pixel 201 for selected steps shown in Figure 6. The shaded region in each potential diagram represents charge.

In step S601, photon integration on the pinned photodiode 207 takes place. During integration the TG 105 is off, corresponding to the potential diagram in Figure 7A, and charge collects on the photodiode. As can be seen from Figure 7A, before charge transfer from the pinned photodiode 207 takes place, the SG 213 is biased to an appropriate potential by the transistor 503 (M7) to make it more positive than the TG at the time when charge is being transferred. The voltage on the SG 213 is buffered by the source follower 505 (M8).

In step S602, a reset pulse is applied to RG2 503. SEL2 509 is also switched on to enable readout of voltage of SG 213. In step S603, the transistor M7 503 is switched off and the reset voltage level on the SG 213 is read out via M8 505 and M9 509 on the output OUT2 507.

In step S605, the charge from the PPD 207 is transferred to the SG 213 using a pulse on the TG 105 as shown in Figure 7B.

In step S607, the TG 105 is turned off (Figure 7C) and the voltage on the SG 213 is read out via the source follower M8 505 and the transistor M9 509 on OUT2 (the select switch 509 remains switched on, as can be seen in Figure 6). The voltage difference on the SG 213 between the states in Figure 7A and Figure 7C (corresponding to steps S601 and S607) is proportional to the charge residing under the SG 213.

High signal level on OUT2 507 indicates that the high gain readout path could be saturated due to the large signal. If this is the case the signal on OUT1 115 may simply be discarded by transferring the charge to the sense node 103, with the reset gate 503 (RG1) switched on.

In step S609, a pulse is applied to RG1 117 and select gate 121 (SEL1) is switched on. In step S611, RG1 117 is switched off and the reset signal level on the sense node 103 to be read out on OUT1 115 via the source follower M5 119 and the switch M6 121.

In step S613, the IG 215 is switched on and the charge under SG 213 is transferred to the sense node 103 as shown in Figure 7D for detection in the same way as described above in relation to Figures 2 and 3.

The sampling of both reset and signal levels in the two readout paths allows correlated double sampling (CDS) to be used. This is particularly important for the signal from the high gain path at OUT1 because low readout noise is only possible when CDS is employed. CDS may not be used if the photon shot noise is much larger than the reset noise at the sense gate 213, which is a condition that could occur at high signal levels. This will simplify and speed up the readout because the reset level does not need to be sampled at time S603 if CDS is not used for the low gain path at OUT2.

To achieve high dynamic range the gain ratio between the two readout paths should be large. In an embodiment, the gain ratio between the high gain path and the low gain path is in the range 5 to 10. In another embodiment, it is in the range 2 to 20. In the embodiment described below, ratio of 10 is chosen. Both signal paths are supplied by the same drain voltage on OD and have nearly identical output voltage spans.

In this embodiment, where the gain ratio is chosen to be 10, if the signal on OUT2 is more than 10% of its saturation level the readout signal on OUT1 can be discarded because OUT1 will be in saturation. If the signal on OUT2 is below 10% of saturation only the signal on OUT1 will be used. In an embodiment, the transition point between the two signals is determined to be just below the saturation level of OUT1. At intermediate signal levels both signals may be combined in order to provide gain calibration of one signal path against the other, or the signals can be averaged.

In an embodiment, the pixel shown in Figures 4 and 5 forms part of an array within an imaging device according to an embodiment, as shown in Figure 1.

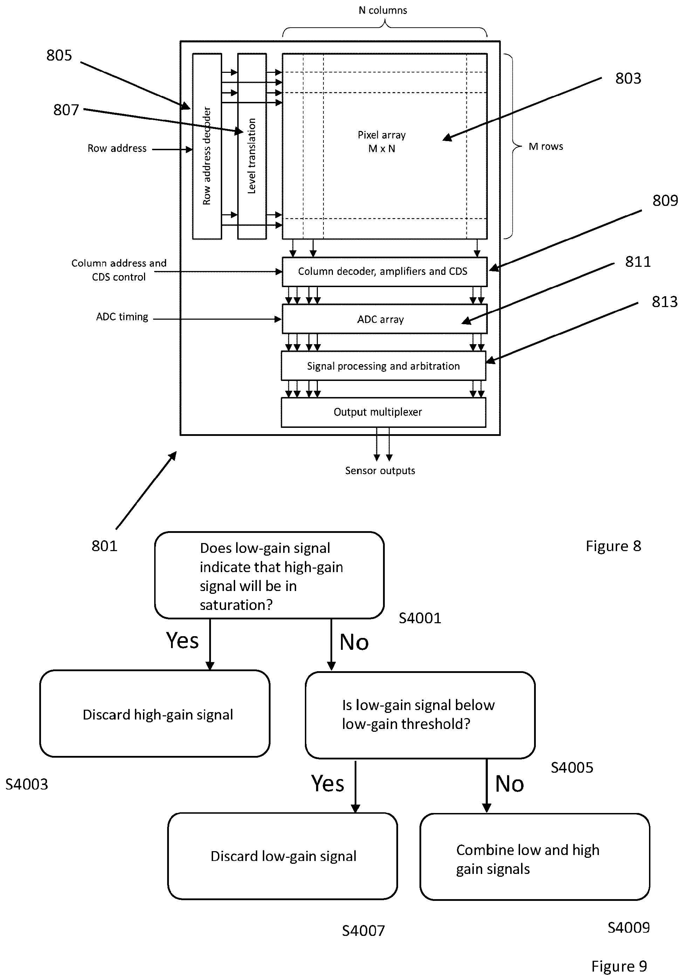

Figure 8 shows a detailed example of processing modules comprised within the imaging device 1 for processing the low and high gain signals described above according to an embodiment. Other arrangements are possible according to other embodiments.

In this embodiment, the imaging device comprises an array 803 having N columns and M rows of pixels acting as optical elements according to embodiments. The imaging device 801 further comprises a row address decoder 805 and level transition module 807. The imaging device 801 further comprises a processing module 809 that acts as a column decoder, which controls the amplifiers and which the process of correlated double sampling (CDS) described above. The imaging device 801 also has an analogue to digital converter array (ADC) 811 and a signal processing and arbitration module 813 which controls the discarding of samples when the saturation exceeds a threshold as described above. Although in the embodiment of Figure 8, these modules are shown as residing inside the imaging device 801, in other embodiments they may reside outside of the sensor. The functioning of these modules will be now be described in detail.

In an embodiment, CMOS imaging device pixels in the array 803 are read out one row at a time. Under non-uniform illumination, typical for real-life applications, some pixels in the row may have large signals, while some may have very little. This means that both low-gain and high-gain signal paths must be read out fully, and the imaging device system has to be able to decide which signal or signals should be used via arbitration.

The imaging device 801 of Figure 8 comprises internal logic for signal arbitration.

During row readout, both the high-gain and low-gain signals from each pixel in the row are digitised by the ADC array. In an embodiment, depending on the magnitude of the two signals, the signal processing and arbitration circuitry 813 decides which signal, or a that combination of both, will be output from each pixel. For example, if the low-gain signal is sufficiently high so that the high-gain path is in saturation, only the low-gain signal will be output and the high-gain one discarded. Conversely, when the high-gain signal is below saturation, but the low-gain signal is very low, so as not to be sufficiently above noise, only the high-gain signal will be output. In an embodiment, when both signals are in their usable range, the signal processing circuit applies a weighting algorithm consisting of scaling followed by summation and will output a weighted sum of both.

A decision chart showing the decision making process performed by the signal processing and arbitration circuitry 813 of selecting a reading according to an embodiment is shown in Figure 9.

In step S4001, the processor compares the value of the low-gain signal with the saturation threshold, i.e. the threshold above which the high-gain signal will be in saturation. If the low-gain signal exceeds this threshold then in step S4003, the high-gain signal is discarded and only the low-gain signal is output by the imaging device 1.

If the low-gain signal does not exceed the saturation threshold, then in step S4005, the low-gain signal is compared with a low-gain threshold. If the low-gain signal is below the threshold then it is discarded in step S4007. If the low-gain signal exceeds the low-gain threshold, then in step S4009, the low and high gain signals are combined in, for example, a weighted sum.

The pixel designs according to embodiments are capable of multiple non-destructive readouts of the low-gain signal paths. In an embodiment, when used in this mode, the signal processing and arbitration circuitry may apply other algorithms. Examples of algorithms employed according to embodiments include averaging of the multiple samples, and linear interpolation.

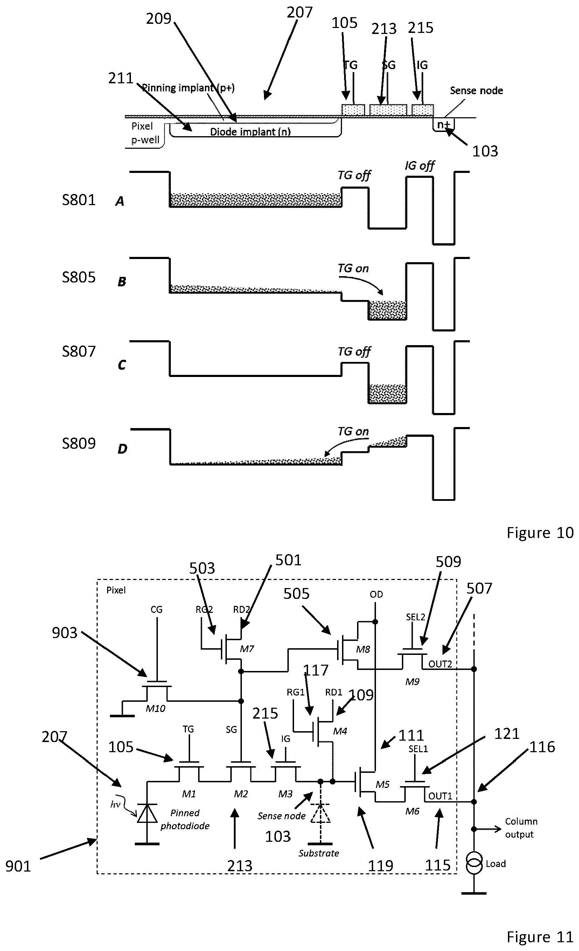

The pixel architecture of pixel 201 allows the charge to be transferred back to the PPD 207 after it has been sensed under SG 213, as shown in Figure 10. Multiple forward and backward transfers between the PPD 207 and the SG 213 are possible, and the charge can be measured each time the signal is under SG 213. The charge can be transferred out from the PPD 207 and measured during signal integration, and then returned to the PPD 207 for further integration.

Figure 10 shows a potential diagram for the operation charge transfer from the SG 213 back to the PPD 207. The steps S801, S805 and S807 are identical to steps S601, S605 and S607, as described above in relation to Figures 6 and 7: the charge is transferred from the PPD 207 to the SG 213 by pulsing the TG 105, followed by charge measurement at SG 213.

In step S809, the charge is then transferred back to the PPD 207 when the TG 105 is turned on, provided that the potential under the SG 213 is more negative than that under the TG 105 and the PPD 207 pinning voltage, as shown in 10D.

In an embodiment, the bias on the SG 213 can be lowered by an additional transistor. A pixel schematic of pixel 901 acting as an optical element according to this embodiment is shown in Figure 11. Pixel 901 is identical to pixel 201, shown in Figures 4 and 5, with the addition of transistor M1 0 903 connected to the SG 213. When a voltage pulse above the transistor gate-source threshold is applied to the Clear Gate (CG) 903 the SG 213 is pulled down to substrate 205 potential, which reduces the potential under the SG 213 to facilitate charge transfer back to the PPD 207, as shown in Figure 10D.

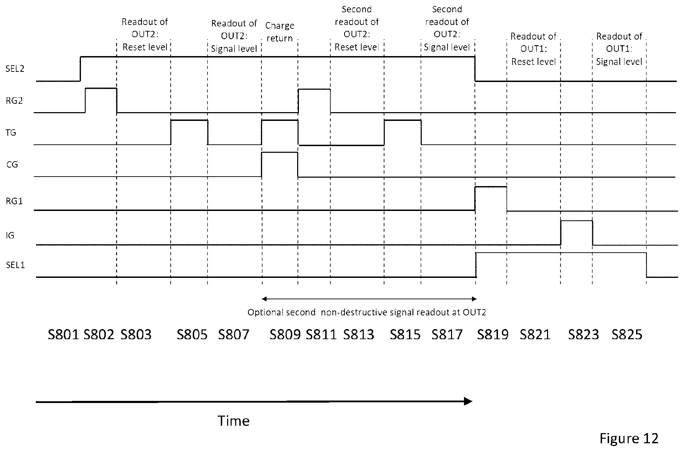

A timing diagram for the circuit according to the embodiment, and corresponding to the potential diagram of Figure 10 is shown in Figure 12, which uses reverse transfer to the PPD 207 and multiple sampling of the signal after each transfer.

In step S801, photon integration on the PPD 207 takes place. During integration the TG 105 is off and charge collects on the photodiode.

In step S802, a reset pulse is applied to RG2 503. SEL2 509 is also switched on to enable readout of the voltage of SG 213. In step S803, the transistor M7 503 (RG2) is switched off and the reset voltage level on the SG 213 is read out via M8 505 and M9 509 on the output OUT2 507.

In step S805, the charge from the PPD 207 is transferred to the SG 213 using a pulse on the TG 105.

In step S807, the TG 105 is turned off and the voltage on the SG 213 is read out via the source follower M8 505 and the transistor M9 509 on OUT2 (the select switch 509 remains switched on, as can be seen in Figure 12).

In step S809, the Clear Gate (CG) 903 and the Transfer Gate (TG) 105 are switched on and charge is transferred back to the PPD 207, as shown in Figure 8D above. Steps S811, S813 S815 and S817 then proceed exactly as S801, S802, S803, S805 and S807, thereby enabling a second non-destructive readout via the low gain circuit and OUT2.

In step S809, a pulse is applied to RG1 117 and select gate 121 (SEL1) is switched on. In step S821, RG1 117 is switched off and the reset signal level on the sense node 103 to be read out on OUT1 115 via the source follower M5 119 and the switch M6 121.

In step S823, the IG 215 is switched on and the charge under SG 213 is transferred to the sense node 103 as shown in Figure 7D for detection in step S825 in the same way as described above in relation to Figures 2 and 3.

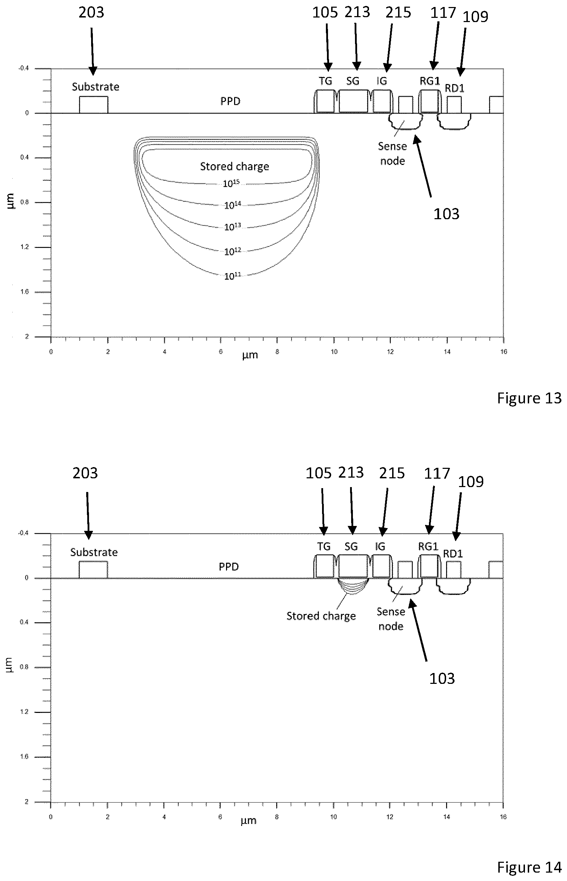

Semiconductor device simulations have been performed in 2-D on a PPD pixel model on 10 µm pitch. After the PPD 207 has collected charge, the electron concentration in units of cm⁻³, corresponding to step S601 in Figure 7A, is shown in Figure 13.

The electron concentration after the charge has been transferred to the SG is shown in Figure 14, corresponding to step S607 in Figure 7C.

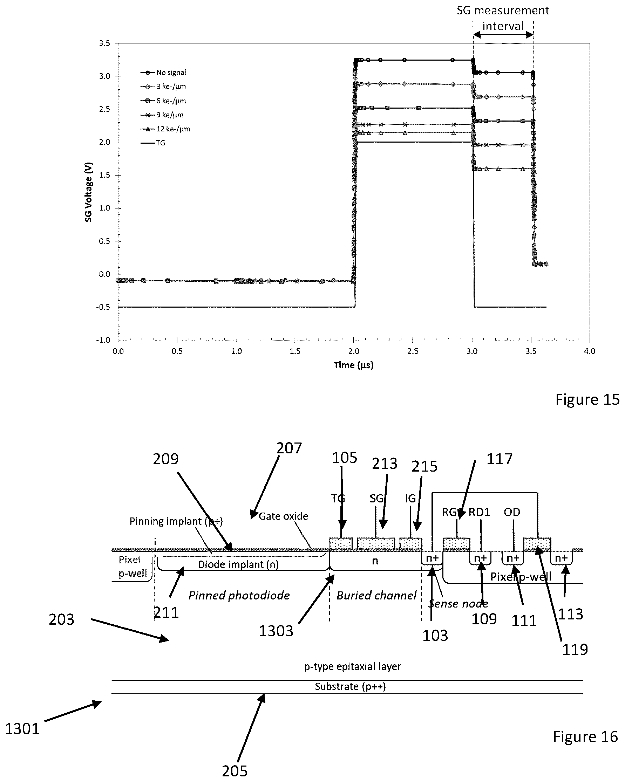

The voltage change at the SG 213 for different sizes of the transferred charge is shown in Figure 15 for a 2-D simulation model with depth of 1 µm. The voltage at the SG 213 is measured when the TG 105 voltage is low after the charge has been transferred from the PPD 207, i.e. corresponding to step S607 as described in relation to Figures 6 and 7 above. The simulation shows nearly linear dependence between the voltage change at the SG 213 and the number of electrons transferred from the PPD 207.

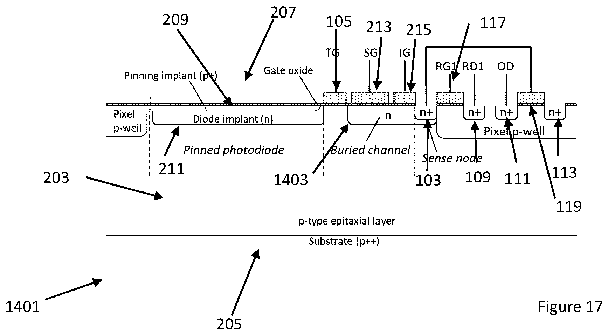

Figures 16 and 17 show cross sectional views of pixels 1301 and 1401, respectively, acting as optical elements according to embodiments.

Pixels 1301 and 1401 are identical to pixel 201 described above in relation to Figures 4 and 5, with the addition of buried channels 1303 and 1404, respectively, located in the epitaxial layer underneath certain gates of the pixel. A buried channel beneath a gate is formed by doping the substrate under the gate with a dopant of the opposite conductivity type than the substrate. In the embodiments of figures 16 and 17, for example, an n-type dopant is employed in a p-type epitaxial layer.

In the embodiment of Figure 16, the buried channel 1303 spans the three gates TG-SG-IG. In the embodiment of Figure 17, the buried channel 1403, spans only SG and IG.

As shown in Figure 4 and 14, between the PPD 207 and the SG 213, charge is transported and stored at the silicon surface along TG-SG-IG. The buried channel arrangement ensures that charge is transported away from any surface traps present in the Si-SiO₂ interface, and therefore may enable improved charge transfer efficiency from the PPD 207 to the SG 213 and the sense node 103.

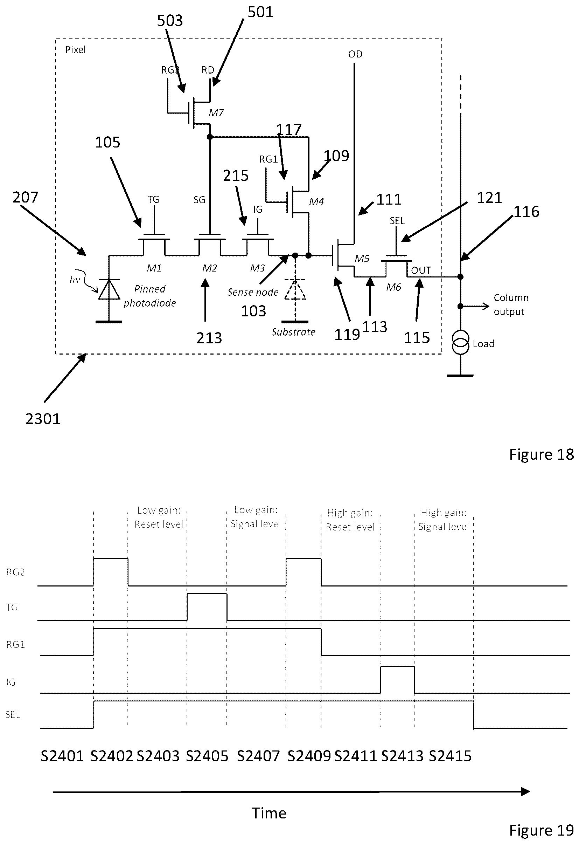

Figure 18 shows a cross sectional view of a pixel 2301 acting as an optical element according to another embodiment. Pixel 2301 is identical to pixel 201 described above in relation to Figures 4 and 5, with the separate source follower 505 and row select transistor 509 for the low-gain signal path removed. The remaining source follower M5 119 and row select transistor M6 121 are shared for the readout of both low-gain and high-gain signal paths. The advantage of this circuit is that it simplifies the pixel design and allows larger part of the pixel to be occupied by the PPD.

In this embodiment, when reading the low-gain signal, the transistor M4 109 is used as a switch and is turned on by an appropriate voltage on its gate RG1 117. In this way, the SG 213 is connected to the gate 119 of the source follower M5 113 and its voltage is read out at the output OUT 115.

The timing diagram for readout with the embodiment of Figure 18 is shown in Figure 19.

In step S2401, photon integration on the pinned photodiode 207 takes place. During integration the TG 105 is off and charge collects on the photodiode.

In step S2402, a reset pulse is applied to RG2 503. SEL 121 and RG1 117 are also switched on to enable readout of the voltage of SG 213.

In step S2403, the transistor M7 503 is switched off and the reset voltage level on the SG 213 is read out via M5 119 and M6 121 on the output OUT 115. RG1 117 is held high to enable this process.

In step S2405, the charge from the PPD 207 is transferred to the SG 213 using a pulse on the TG 105.

In step S2407, the TG 105 is turned off and the voltage on the SG 213 is read out via the source follower M5 119 and the transistor M6 121 on OUT (the select switch 121 and reset gate RG1 117 remain switched on).

In step S2409, a pulse is applied to RG2 503 and select gate 121 (SEL) remains switched on. In step S2411, RG2 503 is switched off and the reset signal level on the sense node 103 is read out on OUT 115 via the source follower M5 119 and the switch M6 121.

In step S2413, the IG 215 is switched on and the charge under SG 213 is transferred to the sense node 103 as shown for detection in step S2415 the same way as described above in relation to Figures 2 and 3.

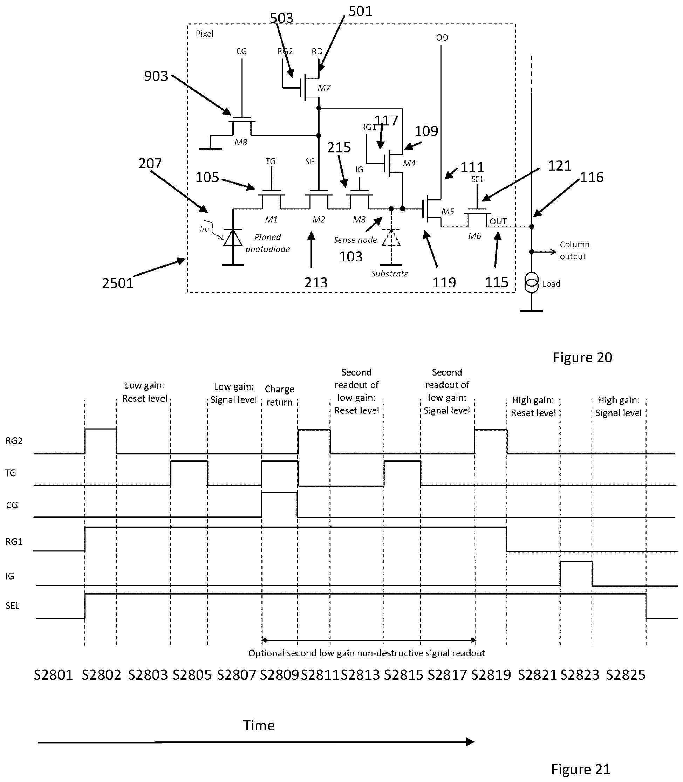

Figure 20 shows the circuit diagram of a pixel 2501 acting as an optical element according to another embodiment. Pixel 2501 is identical to pixel 901 described above in relation to Figure 11, with the separate source follower 505 and row select transistor 509 for the low-gain signal path removed, i.e. transistors M8 505 and M9 509 omitted.

The timing diagram for a readout from pixel 2501 according to an embodiment is shown in Figure 21. This timing diagram in Figure 21 shows one readout of the low-signal path, followed by return of the charge back to the PPD 207. This happens by simultaneously turning the transfer gate (TG) 105 on to allow charge transfer, and the clear gate (CG) 903 to lower the voltage on the SG to substrate potential. Following the return of the charge to the PPD 207, the charge can be transferred back to the SG 213 and sampled again. The transfer of charge between the PPD 207 and the SG 213 can be repeated many times and can provide multiple charge measurements during signal integration.

In detail, in step S2801, photon integration on the pinned photodiode 207 takes place. During integration the TG 105 is off and charge collects on the photodiode.

In step S2802, a reset pulse is applied to RG2 503. SEL 121 and RG1 117 are also switched on to enable readout of the voltage of SG 213.

In step S2803, the transistor M7 503 is switched off and the reset voltage level on the SG 213 is read out via M5 119 and M6 121 on the output OUT 115. RG1 117 is held high to enable this process.

In step S2805, the charge from the PPD 207 is transferred to the SG 213 using a pulse on the TG 105.

In step S2807, the TG 105 is turned off and the voltage on the SG 213 is read out via the source follower M5 119 and the transistor M6 121 on OUT (the select switch 121 and reset gate RG1 117 remain switched on).

In step S2809, a pulse is applied to the clear gate CG 903 and the transfer gate TG 105, thereby enabling the charge under the SG 213 to be returned to the pinned photodiode 207. Steps S2811 to S2817 then proceed exactly as S2802 to S2807, thereby enabling a second non-destructive readout of the charge.

In Step S2819, a pulse is applied to RG2 503 and select gate 121 (SEL) and RG1 117 remain switched on. In step S2821, RG2 503 is switched off and the reset signal level on the sense node 103 is read out on OUT 115 via the source follower M5 119 and the switch M6 121.

In step S2823, the IG 215 is switched on and the charge under SG 213 is transferred to the sense node 103 as shown for detection in step S2825 the same way as described above in relation to Figures 2 and 3.

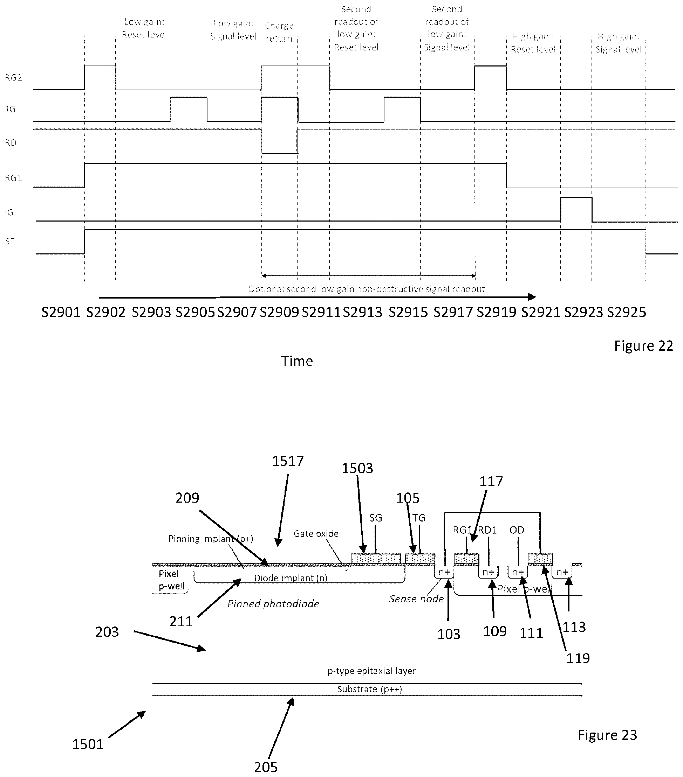

In an embodiment, two low-gain readouts are performed using the circuit shown in Figure 18. In this embodiment, charge return to the PPD 207 in order to enable a second reading is achieved according to the timing diagram in Figure 22. In this embodiment, the lowering of the potential on the SG 213 during reverse charge transfer happens by using the transistor M7 503. When M7 503 is turned on in step S2902, it connects the SG 213 to its drain RD 501, which at this moment has been externally connected to substrate for the duration of time when both the TG 105 and the RG2 503 are high in step S2909. In this way the charge can be returned to the PPD 207 for further charge collection, and then measured again multiple times. The advantage of this method of operation is that the transistor M8 in Figure 20 is eliminated. This simplifies the pixel design and allows larger part of the pixel to be occupied by the PPD 207.

In step S2901, photon integration on the PPD 207 takes place. During integration the TG 105 is off and charge collects on the photodiode.

In step S2902, a reset pulse is applied to RG2 503. SEL 121 and RG1 117 are also switched on to enable readout of the voltage of SG 213.

In step S2903, the transistor M7 RG2 503 is switched off and the reset voltage level on the SG 213 is read out via M5 119 and M6 121 on the output OUT 115. RG1 117 is held high to enable this process.

In step S2905, the charge from the PPD 207 is transferred to the SG 213 using a pulse on the TG 105.

In step S2907, the TG 105 is turned off and the voltage on the SG 213 is read out via the source follower M5 119 and the transistor M6 121 on OUT (the select switch 121 and reset gate RG1 117 remain switched on).

In step S2909, a pulse is applied to RG2 503 and TG 105 and select gate 121 (SEL) remains switched on. At the same time, RD 501 is connected to a substrate in order to lower the potential on SG M2 213. This enables the return of charge to the PPD 207. In step S2911, RD 501 is disconnected from the substrate and TG 105 is switched off. Steps S2913 to S2917 then proceed exactly as steps S2903 to S2907 as described above enabling a second non-destructive charge readout.

In step S2919, a pulse is applied to RG2 503. In step S2921, RG2 503 is switched off and the reset signal level on the sense node 103 is read out on OUT 115 via the source follower M5 119 and the switch M6 121.

In step S2923, the IG 215 is switched on and the charge under SG 213 is transferred to the sense node 103 as shown for detection in step S2925 the same way as described above in relation to Figures 2 and 3.

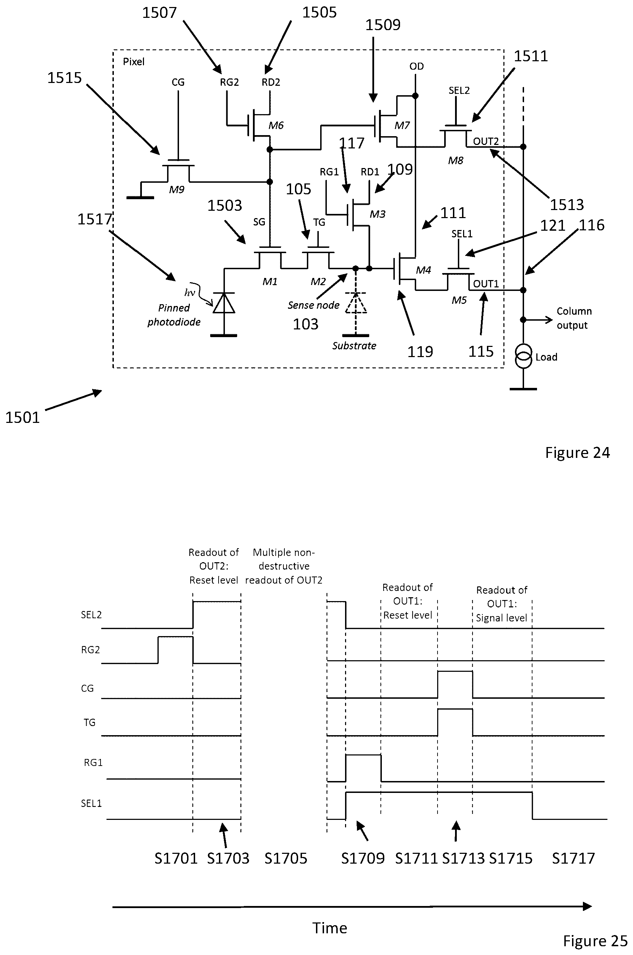

Figures 23 and 24 show cross-sectional views and pixel schematic, respectively, of pixel 1501 acting as an optical element according to an embodiment. The same reference numerals have been employed for corresponding features in both figures. Similarly, features corresponding to those in Figures 2 and 3 are indicated with the same reference numeral as employed in those figures. Note that certain features that appear in Figure 24 have been omitted from Figure 23 for clarity.

In addition to the features described above in relation to Figures 2 and 3, pixel 1501 comprises a floating Sense Gate (SG) 1503 positioned over a part of the PPD 1517 situated next to the TG 105. The part of the PPD over which the SG 1503 is positioned comprises only the diode implant 211; in this embodiment the pinning implant 209 does not extend under the SG 1503.

As described above in relation to the embodiment of Figures 4 and 5, the Sense Gate 1503 is connected to a reset transistor M6 comprising reset drain 1505 and reset gate 1507. The sense gate 1503 is further connected to gate 1509, which acts as a source follower to buffer the potential charge on SG 1503, induced by the stored charge in the PPD 1517, as will be described further below. The pixel comprises a further transistor 1511, configured to enable the voltage of the sense gate 1503 to be sampled at the output OUT2 1513 when the transistor 1511 is switched on.

The skilled person will appreciate that other configurations of readout paths for the voltage induced in the sense gate 1503 are possible.

As described above in relation to the embodiment of Figure 11, pixel 1501 acting as an optical element according to an embodiment further comprises an additional transistor 1515 connected to the SG 1503 which enables the potential of the SG 1503 to be altered as required.

In the embodiment of Figures 23 and 24, due to the absence of pinning implant under the SG 1503, the potential there is higher than in the rest of the PPD 1517 even when the SG 1503 is negatively biased with respect to the substrate and the Si-SiO₂ interface is inverted. The higher potential makes charge collect under the SG 1503 before it spreads over the rest of the PPD 1517 on the left of the SG 1503.

The potential on the sense gate 1503 decreases (if electrons are being collected) as charge is collected in the PPD 1517, and can be read out without interrupting the collection process. After charge collection and measurement on the sense gate 1503, the charge is transferred as usual to the sense node 103 for readout. For this, the sense gate 1503 has to be biased appropriately using transistor 1515 to prevent a potential pocket from occurring and for ensuring efficient charge transfer.

The conversion gain of the sense gate 1503 is low due to the weak capacitive coupling to the charge stored in the PPD 1517. On the other hand, the conversion gain of the sense node 103 can be much higher because its effective capacitance can be made very small, and very low readout noise can be obtained.

Figure 24 shows the full schematic diagram of the pixel 1501. The high conversion gain path is provided by the transistors 117, 119 and 121 and is identical to the readout circuitry in described above in relation to the pixel of Figures 2 and 3. The low conversion gain path is provided by the transistors 1507, 1509 and 1511. The transistor 1515 is used to connect the SG 1503 to substrate during charge transfer.

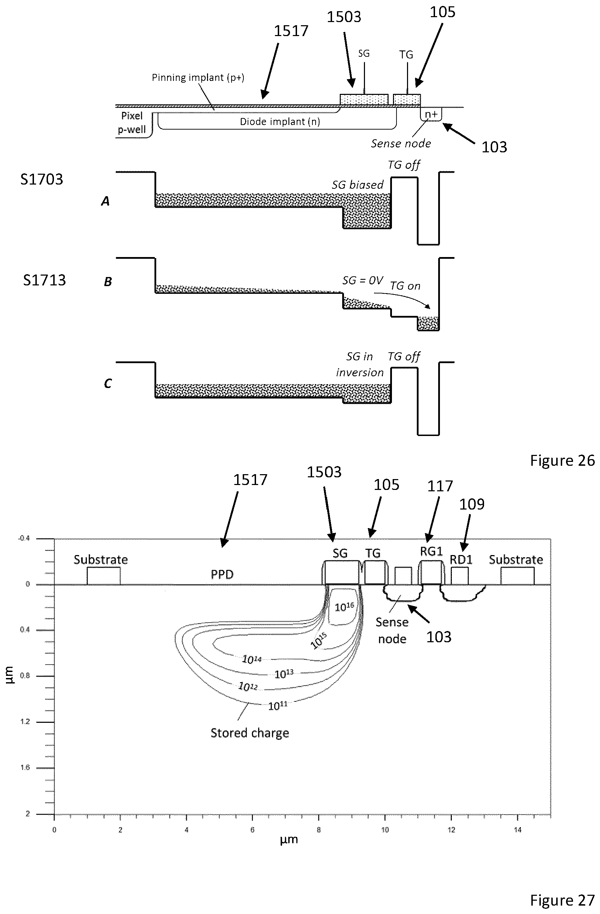

Figure 25 shows a timing diagram for the operation according to an embodiment of pixel 1501. Figure 26 shows a potential diagram for the pinned photodiode 1517, the transfer gate 105 (TG), and the sense gate 1503 (SG) for selected steps shown in Figure 25. The shaded region in each potential diagram represents charge.

In step S1701, before collection commences, the SG 1503 is biased to the voltage at the reset drain RD2 1505 by switching the transistor M6 on by a pulse at its gate RG2 1507. As a result, the potential under SG 1505 becomes significantly higher than the PPD pinning potential. This ensures that charge collects under the SG 1505 during charge collection in step S1703. As more charge is collected it overflows and fills up the rest of the PPD 1517, as shown in the potential diagram in Figure 26A.

During charge collection during steps S1703 and S1705, the potential on SG 1503 can be sampled multiple times on the output OUT2 1513, provided that the transistor 1511 1511 is on and 121 is off. This does not interfere with the collection process because the potential on the SG 1503 is not disturbed. The reset voltage level on the SG 1503 is sampled immediately after the RG2 1507 pulse to allow correlated double sampling to be used.

In step S1709, after charge collection, 1511 (SEL2) is switched off and the sense node 103 is reset by a pulse on the transistor 117. 121 (SEL1) is also switched on. In step S1711, after a pulse on the 117 transistor, the reset voltage level is sampled on the output OUT1 115 as in the readout scheme described in relation to Figures 2 and 3.

In step S1713, the charge in the PPD 1517 is transferred to the sense node 103 when the TG 105 is biased high and the transistor 1515 is turned on by a pulse on the clear gate (CG). This corresponds to the potential diagram in Figure 26B. In step S1715, after charge transfer the signal level is sampled on the output OUT1 115, due to SEL1 121 being biased high.

In the embodiment of Figures 23 and 24, the part of the PPD 1571 under the SG 1503 is not pinned and is expected to have much higher dark current that the rest of the PPD 1571. To mitigate that, the SG 1503 can be brought down to negative voltage with respect to substrate, which will invert the Si-SiO₂ interface and saturate it with holes as shown in Figure 26C. Once taken out of inversion, the electron-hole generation at the Si-SiO₂ interface remains suppressed for considerable time, ranging from milliseconds to seconds and strongly dependant on the temperature, which results in a reduction of the dark current.

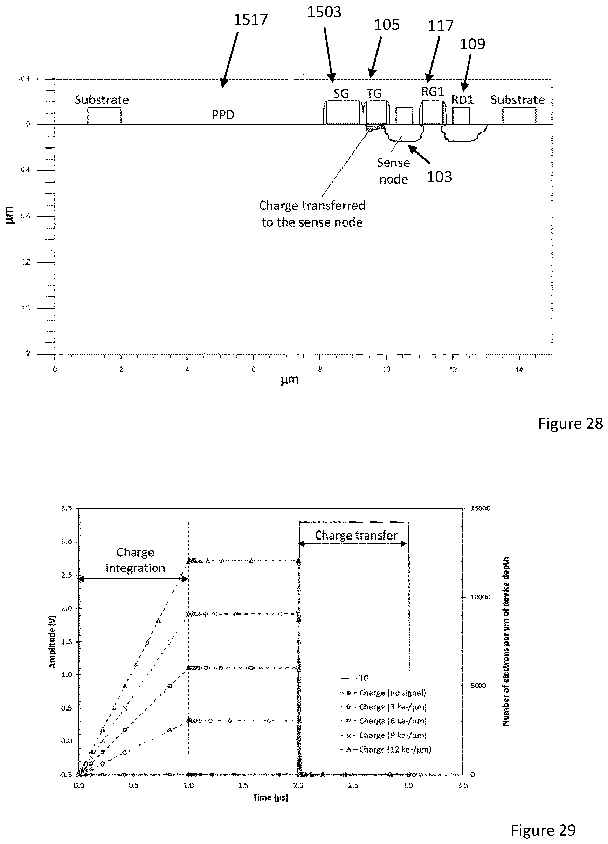

Figure 27 shows a TCAD simulation of the pixel operation during charge collection corresponding to Step S1703 shown in Figure 26A, with the contours depicting the electron density in units of cm⁻³. Figure 28 shows the electron density at time corresponding to Step S1713 shown Figure 26B, when most of the charge has been transferred to the sense node 103.

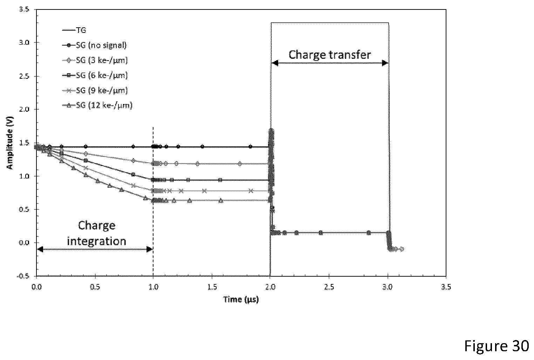

Figure 29 shows the simulated charge in the PPD 1517 versus time at different light levels. The number of electrons in the PPD 1517, plotted on the right hand side scale, increases linearly with time during the 1 µs-long illumination. At the same time, the voltage on the SG 1503 in Figure 30 decreases linearly, and the voltage change at the end of the charge integration is proportional to the amount of charge stored in the PPD 1517. Multiple measurements of the SG 1503 voltage are possible during charge collection.

After integration and measurement at the SG 1503, the charge is transferred to the sense node 103 by pulsing the TG 105 high as shown in Figure 30 (TG plotted on the left hand side scale).

Similarly to the readout timing described in Figure 6, the signal on OUT2 is used when the signal on OUT1 has reached saturation. The gain ratio between the two readout paths should be sufficiently large to achieve high dynamic range. In an embodiment a gain ratio of 10 is employed.

Since charge transfer is not required for signal measurement on OUT2, multiple measurements during integration can be obtained and used to refine the measured value of the output signal. For example, during constant illumination the signal at the SG 1503 decreases linearly with time (if electrons are being collected) and this can be used to linearly extrapolate the signal towards longer integration times. This can be useful when the sensor 1 operates at high frame rates in order to provide a better estimate of the signal. Also, when long integration times are not possible due to signal saturation or very high illumination levels, linear interpolation can be used to further increase the dynamic range of the sensor.

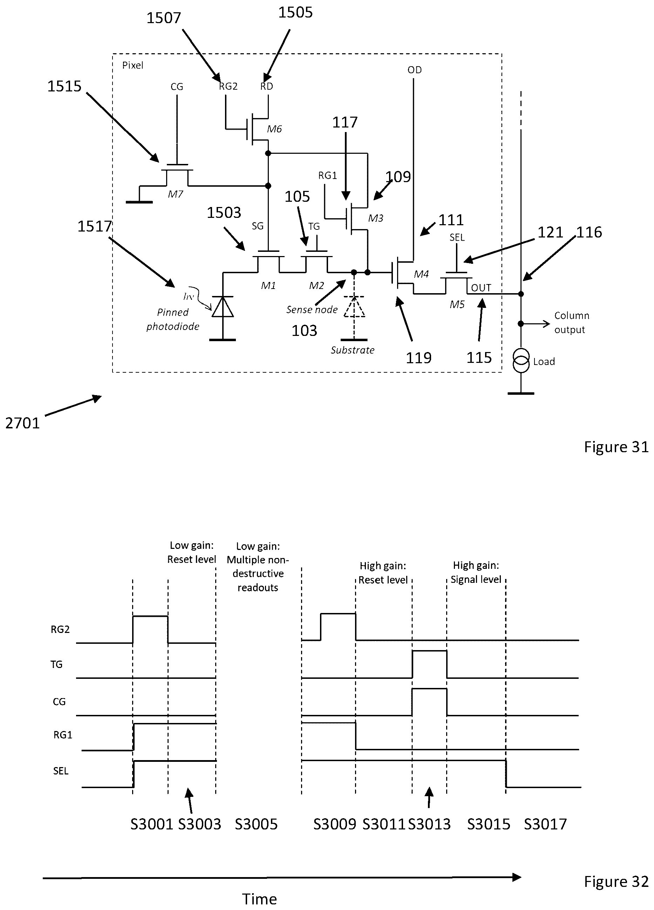

Figure 31 shows a circuit diagram of a pixel 2701 acting as an optical element according to another embodiment. Pixel 2701 is identical to pixel 1501 described above in relation to Figures 23 and 24 with the separate source follower 1509 and row select transistor 1511 for the low-gain signal path removed. The remaining source follower M4 119 and row select transistor M5 121 are shared for the readout of both low-gain and high-gain signal paths.

The timing diagram for the circuit in Figure 31 is shown in Figure 32 according to an embodiment. During the readout of the low-gain signal path the transistor M3 is turned on and connects the sense gate SG 1503 to the gate of the source follower M4. During the readout of the high-gain signal path the transistor M3 is turned off after reset of the sense node. This is followed by charge transfer to the sense node 103, accomplished by lowering the potential on the sense gate SG 1503 by turning the transistor M7 on, while simultaneously pulsing the transfer gate TG 105 high. The steps will now be described in detail.

In step S3001, before collection commences, the SG 1503 is biased to the voltage at the reset drain RD2 1505 by switching the transistor M6 on by a pulse at its gate RG2 1507. As a result, the potential under SG 1503 becomes significantly higher than the PPD 1517 pinning potential. This ensures that charge collects under the SG 1503 during charge collection in step S3005. RG1 117 and SEL 121 are also switched on to enable readout at OUT 115. In Step S3003, RG2 is switched off and the reset level is read out.

During charge collection during steps S3005, the potential on SG 1503 can be sampled multiple times on the output OUT 1513, provided that the RG1 117 and SEL 121 are on. This does not interfere with the collection process because the potential on the SG 1503 is not disturbed. The reset voltage level on the SG 1503 is sampled immediately after the RG2 1507 pulse to allow correlated double sampling to be used.

In step S3009, after charge collection, the sense node 103 is reset by a pulse on the transistor RG2 1507 while RG1 117 and SEL 121 remain switched on. In step S3011, after the pulse on RG2 1507, the reset voltage level is sampled on the output OUT 115 by switching off RG1 117.

In step S3013, the charge in the PPD 1517 is transferred to the sense node 103 when the TG 105 is biased high and the transistor 1515 is turned on by a pulse on the clear gate (CG) 903. In step S3015, after charge transfer the signal level is sampled on the output OUT 115, due to SEL 121 being biased high.

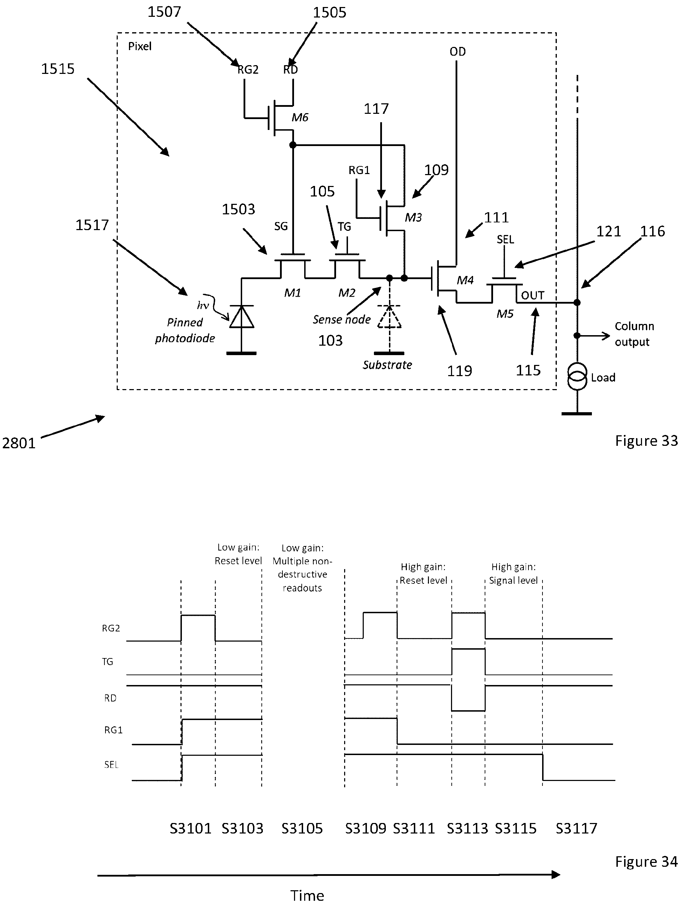

In a further simplification of the circuit in Figure 31, according to an embodiment, the transistor M7 1515 can be removed, resulting in the schematic in Figure 33 with corresponding timing diagram shown in Figure 34. The transistor M3 117 is turned on during the readout of the low-gain signal path. To transfer the charge to the sense node 103 the transfer gate TG 105 is turned on simultaneously with the transistor M6 1507. At the same time the drain voltage at RD 1505 on M6 is lowered externally to substrate potential, and this lowers the potential on the SG 1503 in order to facilitate charge transfer via the TG 105 to the sense node. These steps will now be described in detail.

In step S3101, before collection commences, the SG 1503 is biased to the voltage at the reset drain RD2 1505 by switching the transistor M6 on by a pulse at its gate RG2 1507. As a result, the potential under SG 1503 becomes significantly higher than the PPD pinning potential. This ensures that charge collects under the SG 1503 during charge collection in step S3105. RG1 117 and SEL 121 are also switched on to enable readout at OUT 115. In Step S3103, RG2 is switched off and the reset level is read out.

During charge collection during steps S3105, the potential on SG 1503 can be sampled multiple times on the output OUT 1513, provided that the RG1 117 and SEL 121 are on. This does not interfere with the collection process because the potential on the SG 1503 is not disturbed. The reset voltage level on the SG 1503 is sampled immediately after the RG2 1507 pulse to allow correlated double sampling to be used.

In step S3109, after charge collection, the sense node 103 is reset by a pulse on the transistor RG2 1507 while RG1 117 and SEL 121 remain switched on. In step S3111, after the pulse on RG2 1507, the reset voltage level is sampled on the output OUT 115 by switching off RG1 117.

In step S3113, the charge in the PPD 1517 is transferred to the sense node 103 when the TG 105 is biased high and the drain electrode RD 1505 is connected to a substrate at the same time as RG2 1507 is switched on, thereby lowering the potential on SG 1503. In step S3115, after charge transfer the signal level is sampled on the output OUT 115, due to SEL 121 being biased high.

While certain embodiments have been described, these embodiments have been presented by way of example only, and are not intended to limit the scope of the invention. Indeed, the novel methods, devices and systems described herein may be embodied in a variety of forms; furthermore, various omissions, substitutions and changes in the form of the methods and systems described herein may be made without departing from the scope of the invention.

## Claims

1. An imaging device comprising:
a substrate (205);
a pinned photodiode (207) formed on the substrate, wherein the pinned photodiode generates charge that is representative of incident radiation, and
circuitry for measuring charge, wherein the circuitry defines a first path and a second path,
wherein the first path comprises:
a sense gate electrode (213) formed on the substrate (205) and capacitively coupled to charge in the imaging device; and
circuitry configured to measure the voltage change of the sense gate (213) so as to non-destructively produce a first signal representative of the charge generated in the pinned photodiode (207);
wherein the second path comprises:
a sense node (103) formed on the substrate and configured to receive charge transferred from the pinned photodiode (207); and
circuitry configured to measure the voltage change of the sense node (103), so as to enable measurement of charge transferred from the pinned photodiode and to destructively produce a second signal representative of the charge generated in the pinned photodiode subsequent to the production, by the first path, of the first signal representative of the charge generated in the pinned photodiode (207), and
wherein the first and second paths have different conversion gains and allow measurements of the same charge signal generated in the pinned photodiode (207) with different conversion gains.

2. The imaging device of claim 1, wherein the conversion gain of the second path is higher than the conversion gain of the first path, and wherein the conversion gain ratio between the two paths lies in the range 2 to 20.

3. The imaging device of any of the preceding claims comprising circuitry which is common to both the first and second paths.

4. The imaging device of claim 1, further comprising:
a first region of the substrate located between the pinned photodiode (207) and the sense node (103);
a first gate electrode (105) formed on the substrate and configured to control the transfer of charge from the pinned photodiode (207) to the first region;
a second gate electrode (215) formed on the substrate and configured to control the transfer of charge between the first region and the sense node (103), and wherein
the sense gate electrode (213) is formed on the first region of the substrate and capacitively coupled to charge in the first region.

5. The imaging device of claim 1, the imaging device further comprising:
a first gate electrode (105) formed on the substrate configured to control the transfer of charge between the pinned photodiode (207) and the sense node (103), and wherein
the sense gate electrode is formed on the substrate and is capacitively coupled to charge collected in the photodiode (207).

6. The imaging device of claim 4, wherein:
the first region of the substrate is of a first doping type and wherein the first gate electrode (105) and the second gate electrode (215) are both formed on a region of the substrate of the first doping type, wherein the pinned photodiode (207) is formed on a region of the substrate of a second doping type, wherein the first and second doping types are of opposing polarity, or
wherein the first region of the substrate is of a first doping type, the second gate electrode (215) is formed on a region of the substrate (205) having the first doping type and the first gate electrode (105) is formed on a region of the substrate having a second doping type, wherein the first and second doping types are of opposing polarity.

7. The imaging device of claim 4 or 6, wherein the first gate electrode (105) and the second gate electrode (215) are further configured to control the transfer of charge from the first region back to the pinned photodiode (207).

8. The imaging device of claim 1, wherein the circuitry defining the first path is configured to measure the charge generated in the pinned photodiode (207) via capacitive coupling to the sense gate (213) during charge collection in the pinned photodiode.

9. The imaging device of any of the preceding claims comprising an array of pinned photodiodes (207) and wherein the circuitry defining the first path and the second path are operative to produce signals representative of the charge generated in at least one of the pinned photodiodes.

10. The imaging device of any of the preceding claims, wherein the imaging device is configured to discard the second signal produced by the second path when the first signal produced by the first path exceeds a threshold, wherein the threshold corresponds to a value of the first signal produced by the first path indicating that the second signal produced by the second path is in saturation, and wherein the imaging device is manufactured using CMOS techniques.

11. A method of operating the imaging device according to claim 1, the method comprising:
receiving radiation incident on a pinned photodiode (207) formed on a substrate (205);
generating charge representative of the received radiation;
non-destructively producing a first signal representative of the generated charge;
subsequently destructively producing a second signal representative of the generated charge,
wherein the first signal and the second signal are produced by measuring the same charge signal generated in the pinned photodiode (207) with different conversion gains.

12. The method of claim 11, wherein the second signal is produced with higher conversion gain than the first signal.

## Patentansprüche

1. Bildgebungsvorrichtung, umfassend:
ein Substrat (205);
eine auf dem Substrat gebildete Pinned Photodiode (207), wobei die Pinned Photodiode Ladung erzeugt, die repräsentativ für einfallende Strahlung ist, und
eine Schaltung zum Messen von Ladung, wobei die Schaltung einen ersten Pfad und einen zweiten Pfad definiert,
wobei der erste Pfad Folgendes umfasst:
eine Sense-Gate-Elektrode (213), die auf dem Substrat (205) gebildet und kapazitiv an Ladung in der Bildgebungsvorrichtung gekoppelt ist; und
eine Schaltung, die dazu konfiguriert ist, die Spannungsänderung des Sense-Gates (213) zu messen, um nicht destruktiv ein erstes Signal zu produzierten, das repräsentativ für die in der Pinned Photodiode (207) erzeugte Ladung ist;
wobei der zweite Pfad Folgendes umfasst:
einen Sense-Knoten (103), der auf dem Substrat gebildet und dazu konfiguriert ist, Ladung zu empfangen, die von der Pinned Photodiode (207) übertragen wird; und
einen Schaltkreis, der dazu konfiguriert ist, die Spannungsänderung des Sense-Knotens (103) zu messen, um eine Messung von Ladung zu ermöglichen, die von der Pinned Photodiode übertragen wird, und um destruktiv ein zweites Signal zu produzieren, das repräsentativ für die in der Pinned Photodiode erzeugte Ladung ist, nachdem das erste Signal, das repräsentativ für die in der Pinned Photodiode (207) erzeugte Ladung ist, durch den ersten Pfad produziert wurde, und
wobei der erste und der zweite Pfad unterschiedliche Umwandlungsverstärkungen aufweisen und Messungen des gleichen Ladungssignals, das in der Pinned Photodiode (207) erzeugt wird, mit unterschiedlichen Umwandlungsverstärkungen ermöglichen.

2. Bildgebungsvorrichtung nach Anspruch 1, wobei die Umwandlungsverstärkung des zweiten Pfades höher als die Umwandlungsverstärkung des ersten Pfades ist und
wobei das Umwandlungsverstärkungsverhältnis zwischen den zwei Pfaden im Bereich von 2 bis 20 liegt.

3. Bildgebungsvorrichtung nach einem der vorhergehenden Ansprüche, umfassend eine Schaltung, die sowohl dem ersten als auch dem zweiten Pfad gemeinsam ist.

4. Bildgebungsvorrichtung nach Anspruch 1, ferner umfassend:
eine erste Region des Substrats, die sich zwischen der Pinned Photodiode (207) und dem Sense-Knoten (103) befindet;
eine erste Gate-Elektrode (105), die auf dem Substrat gebildet und dazu konfiguriert ist, die Ladungsübertragung von der Pinned Photodiode (207) zu der ersten Region zu steuern;
eine zweite Gate-Elektrode (215), die auf dem Substrat gebildet und dazu konfiguriert ist, die Ladungsübertragung zwischen der ersten Region und dem Sense-Knoten (103) zu steuern, und wobei
die Sense-Gate-Elektrode (213) auf der ersten Region des Substrats gebildet ist und kapazitiv an Ladung in der ersten Region gekoppelt ist.

5. Bildgebungsvorrichtung nach Anspruch 1, wobei die Bildgebungsvorrichtung ferner Folgendes umfasst:
eine erste Gate-Elektrode (105), die auf dem Substrat gebildet und dazu konfiguriert ist, die Ladungsübertragung zwischen der Pinned Photodiode (207) und dem Sense-Knoten (103) zu steuern, und wobei
die Sense-Gate-Elektrode auf dem Substrat gebildet ist und kapazitiv an in der Photodiode (207) gesammelte Ladung gekoppelt ist.

6. Bildgebungsvorrichtung nach Anspruch 4, wobei:
die erste Region des Substrats ein erster Dotierungstyp ist und wobei sowohl die erste Gate-Elektrode (105) als auch die zweite Gate-Elektrode (215) auf einer Region des Substrats des ersten Dotierungstyps gebildet sind, wobei die Pinned Photodiode (207) auf einer Region des Substrats eines zweiten Dotierungstyps gebildet ist, wobei der erste und der zweite Dotierungstyp entgegengesetzte Polarität aufzeigen, oder
wobei die erste Region des Substrats ein erster Dotierungstyp ist, die zweite Gate-Elektrode (215) auf einer Region des Substrats (205) mit dem ersten Dotierungstyp gebildet ist und die erste Gate-Elektrode (105) auf einer Region des Substrats mit einem zweiten Dotierungstyp gebildet ist, wobei der erste und der zweite Dotierungstyp entgegengesetzte Polarität aufzeigen.

7. Bildgebungsvorrichtung nach Anspruch 4 oder 6, wobei die erste Gate-Elektrode (105) und die zweite Gate-Elektrode (215) ferner dazu konfiguriert sind, die Ladungsübertragung von der ersten Region zurück zu der Pinned Photodiode (207) zu steuern.

8. Bildgebungsvorrichtung nach Anspruch 1, wobei die Schaltung, die den ersten Pfad definiert, dazu konfiguriert ist, die Ladung zu messen, die über eine kapazitive Kopplung mit dem Sense-Gate (213) in der Pinned Photodiode (207) während einer Ladungssammlung in der Pinned Photodiode erzeugt wird.

9. Bildgebungsvorrichtung nach einem der vorhergehenden Ansprüche, umfassend ein Array von Pinned Photodioden (207) und wobei die Schaltung, die den ersten Pfad und den zweiten Pfad definiert, betreibbar ist, um Signale zu produzieren, die repräsentativ für die Ladung sind, die in mindestens einer der Pinned Photodioden erzeugt wird.

10. Bildgebungsvorrichtung nach einem der vorhergehenden Ansprüche, wobei die Bildgebungsvorrichtung dazu konfiguriert ist, das zweite Signal, das durch den zweiten Pfad produziert wird, zu verwerfen, wenn das erste Signal, das durch den ersten Pfad produziert wird, einen Schwellenwert überschreitet, wobei der Schwellenwert einem Wert des ersten Signals entspricht, das durch den ersten Pfad produziert wird, der angibt, dass das zweite Signal, das durch den zweiten Pfad produziert wird, in Sättigung ist, und
wobei die Bildgebungsvorrichtung unter Verwendung von CMOS-Techniken hergestellt wird.

11. Verfahren zum Betreiben der Bildgebungsvorrichtung nach Anspruch 1, wobei das Verfahren Folgendes umfasst:
Empfangen von Strahlung, die auf eine auf einem Substrat (205) gebildete Pinned Photodiode (207) einfällt;
Erzeugen von Ladung, die repräsentativ für die empfangene Strahlung ist;
nicht destruktives Produzieren eines ersten Signals, das repräsentativ für die erzeugte Ladung ist;
anschließendes destruktives Produzieren eines zweiten Signals, das repräsentativ für die erzeugte Ladung ist,
wobei das erste Signal und das zweite Signal durch Messen des gleichen Ladungssignals produziert werden, das in der Pinned Photodiode (207) mit unterschiedlichen Umwandlungsverstärkungen erzeugt wird.

12. Verfahren nach Anspruch 11, wobei das zweite Signal mit höherer Umwandlungsverstärkung als das erste Signal produziert wird.

## Revendications

1. Dispositif d'imagerie comprenant :
un substrat (205) ;
une photodiode à broches (207) formée sur le substrat, ladite photodiode à broches générant une charge qui est représentative du rayonnement incident, et
un circuit de mesure de charge, ledit circuit définissant un premier trajet et un second trajet,
ledit premier trajet comprenant :
une électrode de grille de détection (213) formée sur le substrat (205) et couplée de manière capacitive à la charge dans le dispositif d'imagerie ; et
un circuit configuré pour mesurer la variation de tension de la grille de détection (213) de manière à produire de manière non destructive un premier signal représentatif de la charge générée dans la photodiode à broches (207) ;
ledit second trajet comprenant :
un nœud de détection (103) formé sur le substrat et configuré pour recevoir une charge transférée à partir de la photodiode à broches (207) ; et
un circuit configuré pour mesurer la variation de tension du nœud de détection (103), de manière à permettre la mesure de la charge transférée à partir de la photodiode à broches et à produire de manière destructive un second signal représentatif de la charge générée dans la photodiode à broches suite à la production, par le premier trajet, du premier signal représentatif de la charge générée dans la photodiode à broches (207), et
lesdits premier et second trajets présentant des gains de conversion différents et permettant des mesures du même signal de charge généré dans la photodiode à broches (207) avec des gains de conversion différents.

2. Dispositif d'imagerie selon la revendication 1, ledit gain de conversion du second trajet étant supérieur au gain de conversion du premier trajet, et
ledit rapport de gain de conversion entre les deux trajets étant compris dans la plage de 2 à 20.

3. Dispositif d'imagerie selon l'une quelconque des revendications précédentes comprenant un circuit qui est commun à la fois aux premier et second trajets.

4. Dispositif d'imagerie selon la revendication 1, comprenant en outre :
une première zone du substrat située entre la photodiode à broches (207) et le nœud de détection (103) ;
une première électrode de grille (105) formée sur le substrat et configurée pour commander le transfert de charge de la photodiode à broches (207) à la première zone ;
une seconde électrode de grille (215) formée sur le substrat et configurée pour commander le transfert de charge entre la première zone et le nœud de détection (103), et
ladite électrode de grille de détection (213) étant formée sur la première zone du substrat et couplée de manière capacitive à la charge dans la première zone.

5. Dispositif d'imagerie selon la revendication 1, le dispositif d'imagerie comprenant en outre :
une première électrode de grille (105) formée sur le substrat configurée pour commander le transfert de charge entre la photodiode à broches (207) et le nœud de détection (103), et
ladite électrode de grille de détection étant formée sur le substrat et étant couplée de manière capacitive à la charge collectée dans la photodiode (207).

6. Dispositif d'imagerie selon la revendication 4 :
ladite première zone du substrat étant d'un premier type de dopage et ladite première électrode de grille (105) et ladite seconde électrode de grille (215) étant toutes deux formées sur une zone du substrat du premier type de dopage, ladite photodiode à broches (207) étant formée sur une zone du substrat d'un second type de dopage, lesdits premier et second types de dopage étant de polarité opposée, ou
ladite première zone du substrat étant d'un premier type de dopage, ladite seconde électrode de grille (215) étant formée sur une zone du substrat (205) présentant le premier type de dopage et ladite première électrode de grille (105) étant formée sur une zone du substrat présentant un second type de dopage, lesdits premier et second types de dopage étant de polarité opposée.

7. Dispositif d'imagerie selon la revendication 4 ou 6, ladite première électrode de grille (105) et ladite seconde électrode de grille (215) étant en outre configurées pour commander le transfert de charge de la première zone à la photodiode à broches (207).

8. Dispositif d'imagerie selon la revendication 1, ledit circuit définissant le premier trajet étant configuré pour mesurer la charge générée dans la photodiode à broches (207) par le biais d'un couplage capacitif à la grille de détection (213) pendant la collecte de charge dans la photodiode à broches.

9. Dispositif d'imagerie selon l'une quelconque des revendications précédentes comprenant un réseau de photodiodes à broches (207) et lesdits circuits définissant le premier trajet et le second trajet étant efficaces pour produire des signaux représentatifs de la charge générée dans au moins l'une des photodiodes à broches.

10. Dispositif d'imagerie selon l'une quelconque des revendications précédentes, ledit dispositif d'imagerie étant configuré pour rejeter le second signal produit par le second trajet lorsque le premier signal produit par le premier trajet dépasse un seuil, ledit seuil correspondant à une valeur du premier signal produit par le premier trajet indiquant que le second signal produit par le second trajet est en saturation, et
ledit dispositif d'imagerie étant fabriqué à l'aide de techniques CMOS.

11. Procédé de fonctionnement du dispositif d'imagerie selon la revendication 1, le procédé comprenant :
la réception du rayonnement incident sur une photodiode à broches (207) formée sur un substrat (205) ;
la génération d'une charge représentative du rayonnement reçu ;
la production de manière non destructive d'un premier signal représentatif de la charge générée ;
la production consécutive de manière destructive d'un second signal représentatif de la charge générée,
lesdits premier et second signaux étant produits en mesurant le même signal de charge généré dans la photodiode à broches (207) avec des gains de conversion différents.

12. Procédé selon la revendication 11, ledit second signal étant produit avec un gain de conversion plus élevé que le premier signal.
